# EUROPEAN PATENT APPLICATION

(11) **EP 2 363 883 A1**
(43) Date of publication of application: **07.09.2011**
(21) Application number: 10189054.9
(22) Date of filing: 27.10.2010
(51) Int. Cl.: H01L 23/538, H01L 23/00

(54) **Connecting pad producing method**

(30) Priority: 03.03.2010 JP 2010046722
(71) Applicant: Omron Corporation, Kyoto-shi, Kyoto 600-8530 (JP)
(72) Inventor: Kuratani, Naoto, Kyoto-shi, Kyoto 600-8530 (JP); Ono, Kazuyuki, Kyoto-shi, Kyoto 600-8530 (JP); Maekawa, Tomofumi, Kyoto-shi, Kyoto 600-8530 (JP)
(74) Representative: Wilhelms · Kilian & Partner Patentanwälte

(57) **Abstract**

A frame-shaped insulating portion (49) is projected in an upper surface of a cover (44) so as to surround a region where a bonding pad (48) is to be formed. Then a metallic film (68) is formed in the whole upper surface of the cover (44) such that the insulating portion 49 is coated therewith. Then the metallic film 68 with which the insulating portion (49) is coated is ground with a dicer to expose the whole periphery of the insulating portion (49) from the metallic film (68), thereby forming the independent bonding pad (48) in the region surrounded by the insulating portion (49). The metallic film (68) located outside the insulating portion (49) constitutes an electromagnetically=shielding conductive layer (47).

## Description

### BACKGROUND OF THE INVENTION

### 1. TECHNICAL FIELD

The present invention relates to a connecting pad producing method, specifically to a method for connecting pad in a semiconductor element accommodating package.

### 2. RELATED ART

US Patent Application Publication Nos. 2008/0283988 (US 2008/0283988A1) and 2007/0058826 (US 2007/0058826Al) disclose semiconductor devices in which MEMS elements and lC chips are incorporated, and the semiconductor devices include electromagnetically-shielding conductive layers that are formed such that a whole inside of the package is substantially coated therewith. In the semiconductor device of US Patent Application Publication No. 2008/0283988 (US 2008/0283988A1), the package includes a substrate and a cover having a recess, and the MEMS element is mounted in the recess of the cover.

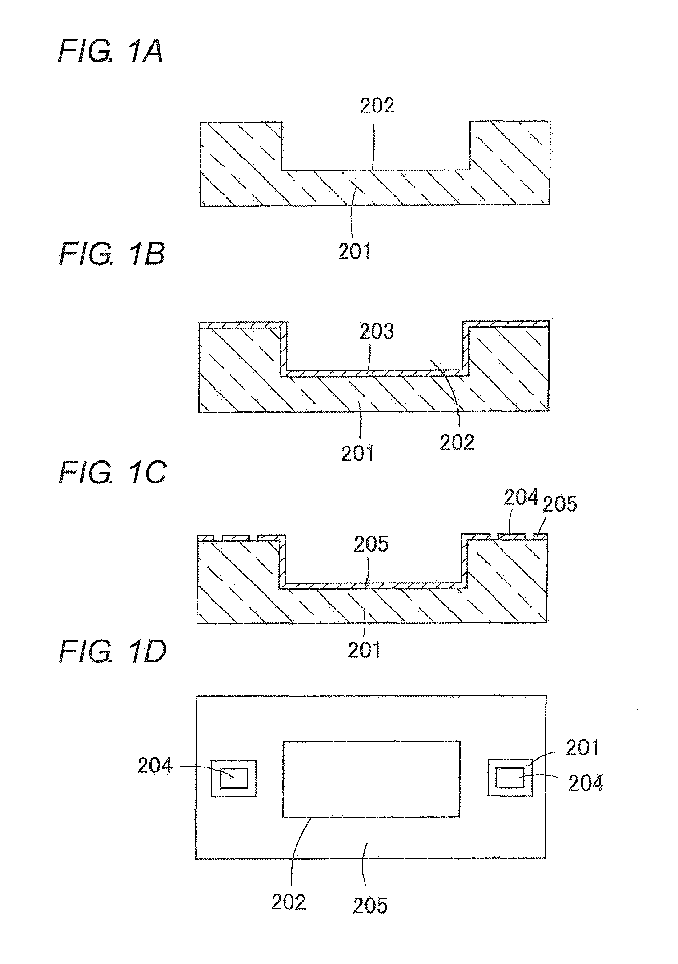

For example, a method illustrated in Figs. 1A to 1D is adopted as a method for forming a connecting pad such as an independent bonding pad for connecting a bonding wire on an inner surface side of the cover.

A cover 201 illustrated in Fig. 1A in which a recess 202 is formed in an upper surface is used in the method of Fig. 1. As illustrated in Fig. 1B, a metallic film 203 is formed in an inner surface of the recess 202 and the upper surface of the cover 201. Then, as illustrated in Figs. 1C and 1D, the metallic film 203 is patterned by a photolithographic technique, a connecting pad 204 is provided in a predetermined region, and an electromagnetically-shielding conductive layer 205 is formed on the whole surface except the predetermines region.

However, in the method, because the metallic film 203 is patterned by the photolithographic technique, a photoresist applying process, a photoresist exposing process, a photoresist patterning process, a process of etching the metallic film 203, and a photoresist peeling process are required in the process of patterning the metallic film 203. Additionally, in order to securely insulate the connecting pad 204 and the conductive layer 205 from each other, it is necessary to bury a conductive material in a region exposed to the cover 201 between the connecting pad 204 and the conductive layer 205 after the process of Figs. 1C and 1D. As a result, in the method illustrated in Fig. 1, a process of preparing the connecting pad 204 becomes complicated to increase cost.

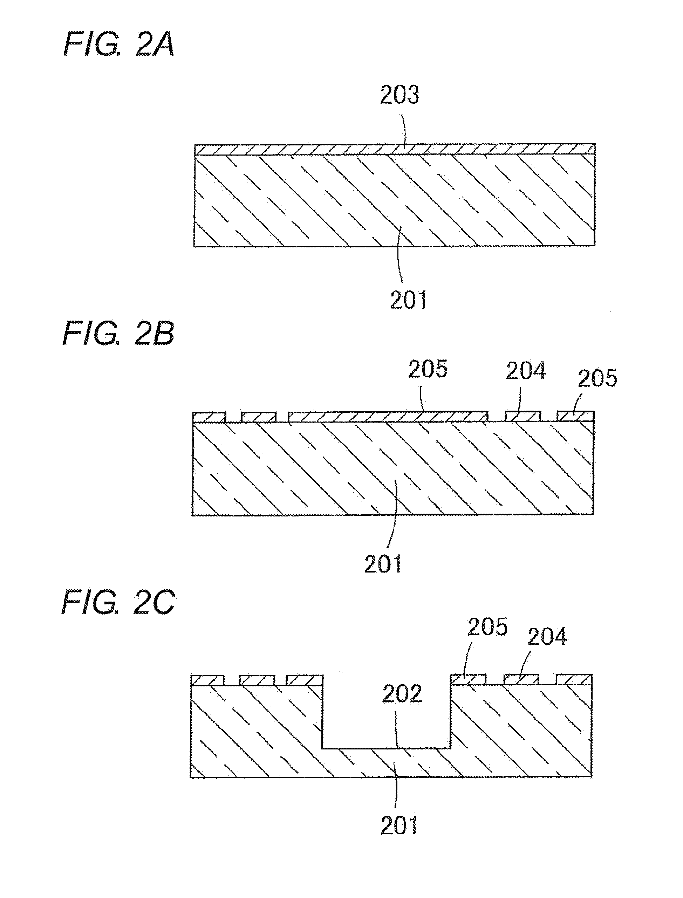

A method illustrated in Fig. 2 is adopted as another method for forming the connecting pad. In the method of Fig. 2, the metallic film 203 is deposited on the upper surface of the plate-like cover 201 as illustrated in Fig. 2A. Then, as illustrated in Fig. 2B, the metallic film 203 is patterned by the photolithographic technique to form the connecting pad 204 and the conductive layer 205 in the upper surface of the cover 201. As illustrated in Fig. 2C, the conductive layer 205 and the cover 201 are ground to provide the recess 202 in the cover 201.

In the method, the photolithographic technique is required to pattern the metallic film 203 to form the connecting pad 204 as illustrated in Fig. 2B. It is necessary to further deposit the conductive layer in the recess 202 after the recess 202 is formed. Therefore, it is necessary to provide a protective film to protect the connecting pad 204. Further, in order to securely insulate the connecting pad 204 and the conductive layer 205 from each other, it is necessary to bury the conductive material between the connecting pad 204 and the conductive layer 205. As a result, in the method of Fig. 2, the process becomes complicated to increase the cost.

### SUMMARY

The present invention has been devised to solve the problems described above, and an object thereof is to a method for being able to reasonably and inexpensively produce a connecting pad in a semiconductor device package.

In accordance with one aspect of the present invention, a connecting pad producing method includes: a first process of projecting an insulating member in a surface of a base material such that a region where a connecting pad is formed is surrounded; a second process of forming a conductive layer in the surface of the base material such that the insulating member is coated with the conductive layer; and a third process of removing the conductive layer with which the insulating member is coated, exposing the insulating member over a whole periphery from the conductive later, and forming the connecting pad including the conductive layer in a region surrounded by the insulating member.

In the invention, when the insulating member is formed in the surface of the base material before the conductive layer is deposited on the base material, the independent connecting pad can be prepared only by removing the conductive layer to expose the insulating member. Accordingly, it is not necessary to pattern the conductive layer by the photolithographic technique, but the connecting pad can be prepared through the simple process and the connecting pad can inexpensively be prepared. Additionally, the insulating property of the connecting pad is improved, because the insulating member is buried between the connecting pad and the conductive layer outside the connecting pad.

In the connecting pad producing method of the invention, preferably the insulating member is formed integral with the base material in the first process, or preferably the insulating member is formed by adding an insulating material to the surface of the base material in the first process. The method for integrally forming the insulating member and the base material is effectively adopted when the base material is also made of the conductive material, and the method has an extreme advantage from the viewpoint of coast. The method for forming the insulating member by adding the conductive material, to the base material has versatility and can be applied to a base material in which forming is hardly performed.

Further, preferably the conductive layer is provided in the surface of the base material having conductivity through a coated film made of an insulating material in the second process, which allows use of the base material having the conductivity, for example, the metallic base material.

In the connecting pad producing method of the invention, preferably the conductive layer with which the insulating member is coated is removed so as not to reach the conductive layer surface in a region adjacent to the insulating member in the third process. Therefore, according to this aspect, a level of an edge of the connecting pad is increased. When the connecting pad is joined using a conductive bonding agent or solder, the conductive bonding agent or solder hardly runs over, and the conductive bonding agent or solder can be prevented from coming into contact with the conductive layer outside the connecting pad.

Preferably the conductive layer with which the insulating member is coated and the insulating member are removed to a surface of the conductive layer in a region adjacent to the insulating member in the third process. Therefore, according to this aspect, because the connecting pad is flattened, the bonding wire is easily performed.

Preferably the conductive layer is removed by machine work in the third process. Examples of the machine work include cutting, grinding, and polishing. According to these methods, the insulating member can simply and inexpensively be exposed compared with etching or laser forming.

When the conductive layer outside the region surrounded by the insulating member is an electromagnetic shield, it is not necessary to remove the conductive layer outside the connecting pad. Therefore, the connecting pad producing method of the invention is particularly effectively adopted in such cases.

In the connecting pad producing method of the invention, preferably the base material include a recess, the insulating member is formed in the surface of the base material in a region outside the recess in the first process, and the conductive layer is formed in the whole surface of the base material including an inner surface of the recess in the second process. For the base material including the recess, according to this aspect, it is not necessary to retro-provide the conductive layer in the recess unlike the conventional method illustrated in Fig. 2.

In the connecting pad producing method of the invention, preferably the base material is a member that constitutes at least part of a package for accommodating a semiconductor element. Therefore, the connecting pad producing method is effectively adopted as a method for producing the package that accommodates the semiconductor element therein.

The means for solving the problem in the invention has the feature that the above-described constituents are appropriately combined, and many variations can be made by combining the constituents in the invention.

### BRIEF DESCRIPTION OF THE DRAWINGS

Figs. 1A to 1D are schematic sectional views and a plan view for explaining a conventional connecting pad producing method;
Figs. 2A to 2C are schematic sectional views for explaining another conventional connecting pad producing method;
Fig. 3 is a sectional view illustrating a semiconductor device according to a first embodiment of the invention;
Fig. 4A is a plan view of a cover used in the semiconductor device of the first embodiment, and Fig. 4B is a plan view of a substrate for a package used in the semiconductor device of the first embodiment;
Figs. 5A to 5E are schematic sectional views illustrating processes of producing the semiconductor device of the first embodiment;
Figs. 6A to 6C are schematic sectional views illustrating processes of producing the semiconductor device of the first embodiment and illustrate the processes subsequent to the process of Fig. 5E;
Figs. 7A to 7D are schematic sectional views illustrating processes of producing the semiconductor device of the first embodiment and illustrate the processes subsequent to the processes of Figs. 6A to 6C;
Figs. 8A to 8C are perspective view illustrating a state in which a bonding pad is prepared;
Fig. 9 is a sectional view illustrating a semiconductor device according to a second embodiment of the invention;
Figs. 10A to 10C are schematic sectional views illustrating processes of producing the semiconductor device of the second embodiment;
Figs. 11A to 11C are schematic sectional views illustrating processes of producing the semiconductor device of the second embodiment and illustrate the processes subsequent to the process of Fig. 10C;
Fig. 12 is a sectional view illustrating a semiconductor device according to a third embodiment of the invention;
Figs. 13A to 13E are schematic sectional views illustrating processes of producing the semiconductor device of the third embodiment;
Fig. 14 is a sectional view illustrating a semiconductor device according to a fourth embodiment of the invention; and
Figs. 15A to 15F are schematic sectional views illustrating processes of producing the semiconductor device of the fourth embodiment.

### DETAILED DESCRIPTION

Hereinafter, preferred embodiments of the present invention will be described with reference to the drawings. However, the invention is not limited to the following embodiments, but various design changes can be made without departing from the scope of the invention.

### (First Embodiment)

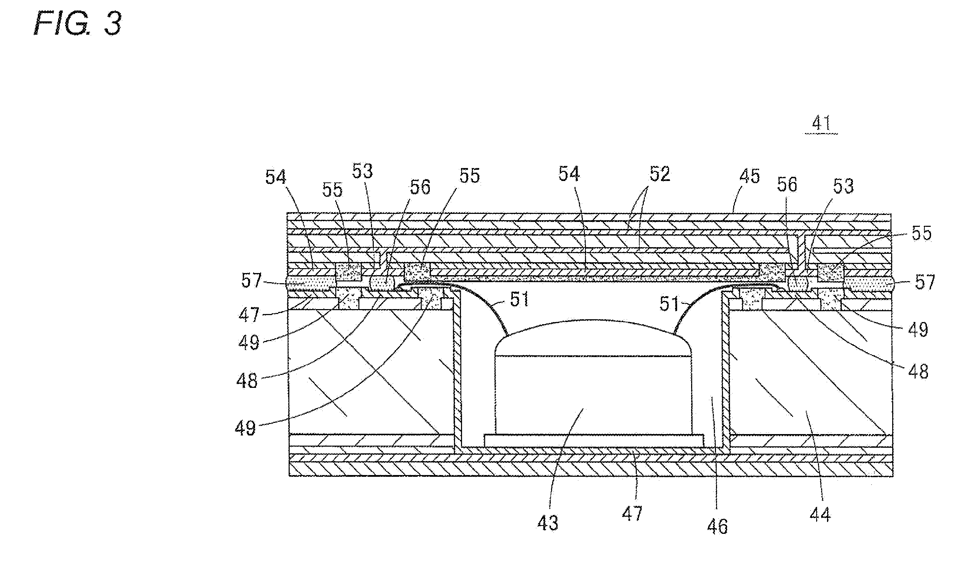

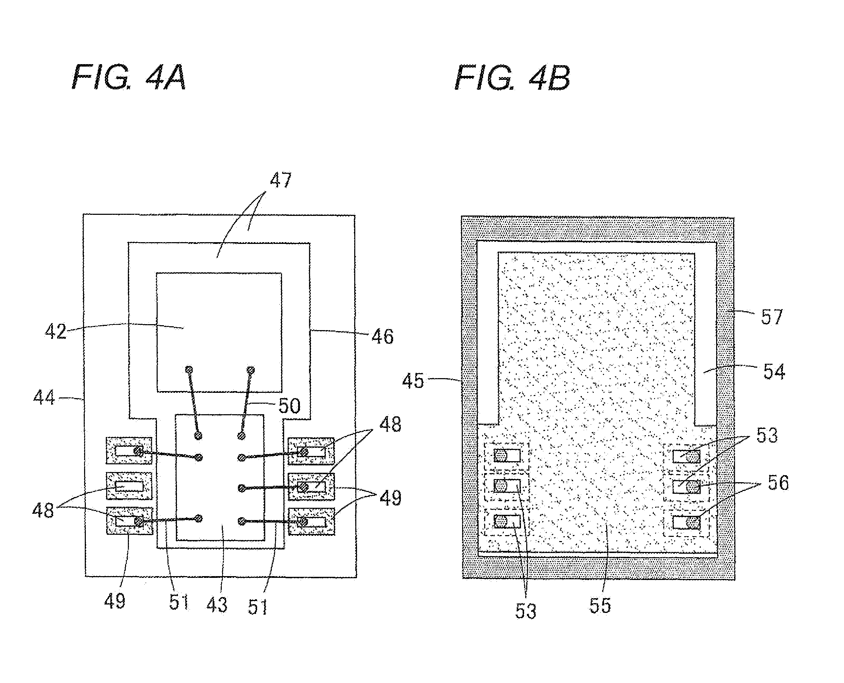

A semiconductor device according to a first embodiment of the invention will be described with reference to Figs. 3 to 8. In a semiconductor device 41, a sensor 42 and a circuit element 43 are accommodated in a package including a cover 44 (base material) and a substrate 45. A copper-clad laminate is used in the semiconductor device 41 of the first embodiment. Fig. 3 is a sectional view of the semiconductor device 41 of the first embodiment, Fig. 4A is a plan view of the cover 44 on which the sensor 42 and the circuit element 43 are mounted, and Fig. 4B is a bottom view of the substrate 45 on which conductive members 56 and 57 are applied. In the drawings, the cover 44 is attached to a lower surface of the substrate 45, and this indicates the producing process. In the usage state, the semiconductor device 41 may be oriented toward any direction.

As illustrated in Figs. 3 and 4A, the cover 44 includes a recess 46 that is formed into a box shape to accommodate the sensor 42 and the circuit element 43 therein. As described in the producing method, the cover 44 includes the copper-clad laminate in which a through-hole is made and a bottom-surface substrate. The bottom surface of the recess 46 is closed white the upper surface is opened. An electromagnetically-shielding conductive layer 47 is formed in the substantial whole of the bottom surface and sidewall surface of the recess 46 and the upper surface of the cover 44 outside the recess 46. Outside the recess 46, that is, in the upper surface of the cover 44, a plurality of bonding pads 48 (connecting pad) are formed near the recess 46. The conductive layer 47 and the bonding pad 48 are formed by a metallic film, a periphery of the bonding pad 48 is separated from the conductive layer 47, and each of the bonding pads 48 and the conductive layer 47 are separated from each other by burying an insulating portion 49 made of an insulating material such as a photoresist in the periphery of the bonding pad 48.

The sensor 42 is an MEMS element such as a MEMS microphone, and the circuit element 43 is an element such as an IC chip and an ASIC. The sensor 42 and the circuit element 43 are accommodated in the recess 46, and the lower surfaces of the sensor 42 and circuit element 43 are fixed to the bottom surface of the recess 46 by a bonding agent. A terminal provided in the upper surface of the sensor 42 and a terminal provided in the upper surface of the circuit element 43 are connected by a bonding wire 50. One end of a bonding wire 51 is bonded to the terminal provided in the upper surface of the circuit element 43, and the other end of the bonding wire 51 is bonded to the bonding pad 48. In Fig. 4A, the bonding pad 48 is disposed near the circuit element 43. Alternatively, the bonding pad 48 may appropriately be provided near the sensor 42 when the sensor 42 and the bonding pad 48 are connected by the bonding wire.

As illustrated in Figs. 3 and 4B, the substrate 45 includes a multilayer wiring substrate, and an input/output wiring 52 for signal input/output is provided in the substrate 45. In the lower surface of the substrate 45, a connecting pad portion 53 is provided opposite the bonding pad 48, and an electromagnetically-shielding ground electrode layer 54 is provided in the substantially whole surface except the connecting pad portion 53 and the periphery of the connecting pad portion 53. The connecting pad portion 53 and the ground electrode layer 54 are formed by a metallic film, and the periphery of the connecting pad portion 53 is separated from the ground electrode layer 54. In the region except the connecting pad portion 53 and an outer peripheral portion of the ground electrode layer 54, the lower surface of the ground electrode layer 54 is coated with a solder resist 55, and a gap between the connecting pad portion 53 and the ground electrode layer 54 is filled with the solder resist 55. Each of the connecting pad portions 53 is electrically connected to the input/output wiring 52 of the substrate 45.

As illustrated in Fig. 3, the substrate 45 is overlapped on the upper surface of the cover 44, and the bonding pad 48 and the connecting pad portion 53 are joined opposite each other by a conductive member 56 such as a conductive bonding agent and solder. In the ground electrode layer 54, the region exposed from the solder resist 55 in the outer peripheral portion of the substrate is joined to the outer peripheral portion of the conductive layer 47 by a conductive member 57 such as a conductive bonding agent and solder. Accordingly, the circuit element 43 is connected to the input/output wiring 52 through the bonding wire 51 and the conductive member 56. Because the conductive layer 47 is electrically connected to the ground electrode layer 54 by the conductive member 57, the inside of the semiconductor device 41 is electrically shielded by connecting the ground electrode layer 54 to a ground potential.

### (Producing Method)

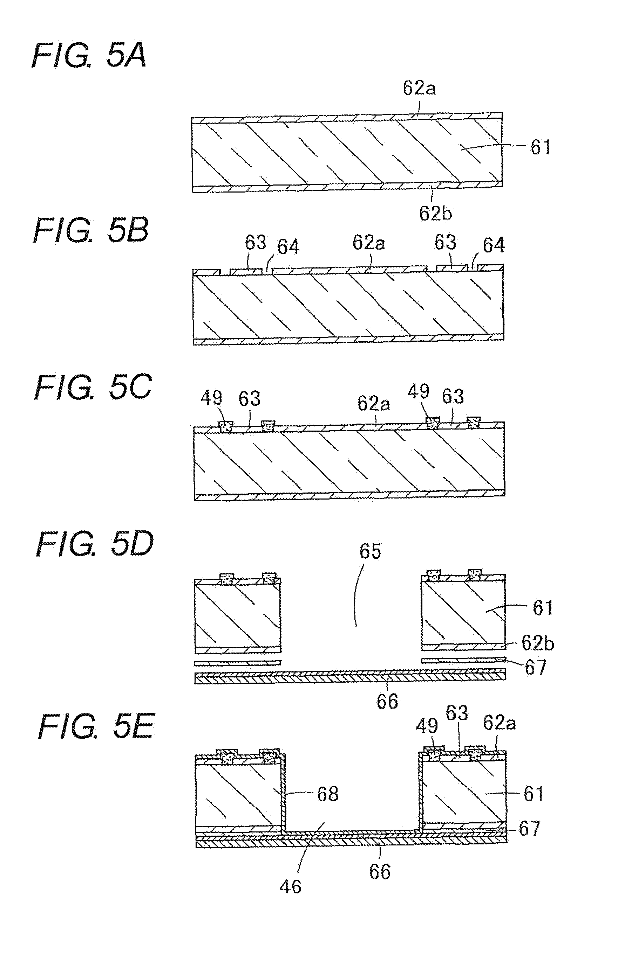

Then a method for producing the semiconductor device 41 will be described with reference to Figs. 5A to 5E, Figs. 6A to 6C, and Fig. 7A to 7D. Fig. 5A illustrates a raw material of the cover 44, for example, a two-layer copper-lad laminate 61 in which copper foils 62a and 62b are bonded to upper and lower surfaces. As illustrated in Fig. 5B, in the upper-surface copper foil 62a, the periphery of the region where the bonding pad 48 should be formed is removed by etching to form a separation groove 64, and an island 63 is formed in the region where the bonding pad 48 should be formed. Then a photoresist is applied onto the upper surface of the copper-clad laminate 61, and the photoresist is patterned by the photolithographic technique such that the photoresist is left only in the separation groove 64. As a result, as illustrated in Fig. 5C, the insulating portion 49 is formed in a projected frame shape in the periphery of the island 63 by the cured photoresist.

Then, as illustrated in Fig. 5D, a through-hole 65 is made in the copper-clad laminate 61 with a router or a drill so as to be aligned with the region that constitutes the recess 46. A bottom-surface substrate 66 is bonded to the whole lower surface of the copper-clad laminate 61 by a dauble-sided adhesive tape 67, and the lower surface of the through-hole 65 is closed by the bottom-surface substrate 66 to form the recess 46 in the copper-clad laminat 61. The bottom-surface substrate 66 is not limited to the hard substrate, but a heat-resistant tape or a heat-resistant sheet may be used as the bottom-surface substrate 66.

In grinding the copper-clad laminate 61 with the router or the drill, a method for ending the forming before the copper-clad laminate 61 is pierced through the lower surface of the copper-clad laminate 61 may be adopted as the method for forming the recess 46 in the copper-clad laminate 61. However, a high-precision processing machine is required to the recess 46 with the thin bottom surface left, or to smoothly form the bottom surface of the recess 46. On the other hand, in the method for bonding the bottom-surface substrate 66 after the through-hole 65 is made in the copper-clad laminate 61, a depth of the recess 46 and a thickness of the bottom surface can easily be controlled. Additionally, because the surface of the bottom-surface substrate 66 constitutes the bottom surface of the recess 46, the bottom surface of the recess 46 is easily smoothed.

After the bottom-surface substrate 66 is bonded to the copper-clad laminate 61 to form the recess 46, a metallic film 68 is deposited in the inner surface of the recess 46 and the whole upper surface of the copper-clad laminate 61 by a method such as vapor deposition and sputtering as illustrated in Fig. 5E.

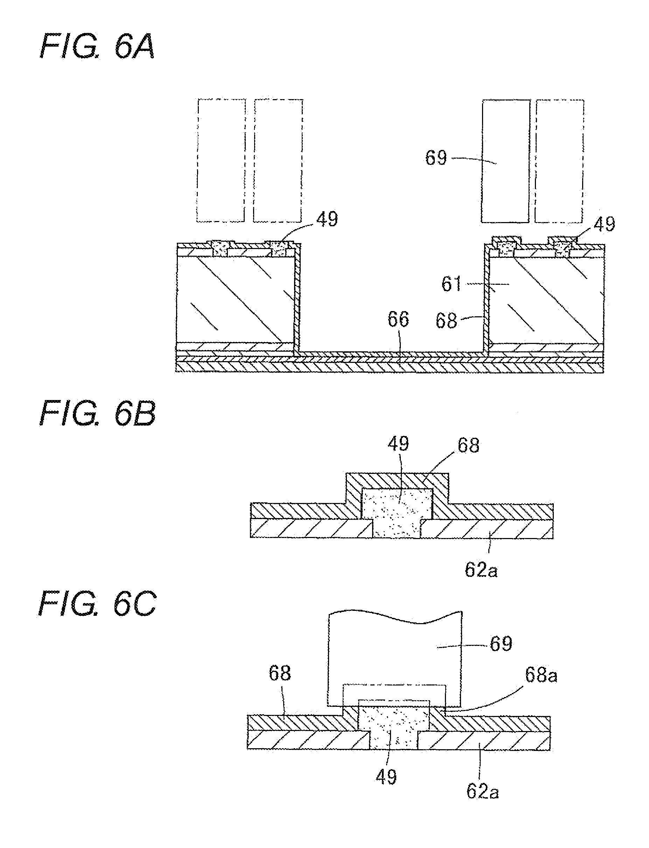

Because a height of the insulating portion 49 is larger than a thickness of the copper foil 62a, the metallic film 68 with which the insulating portion 49 is coated rises from the periphery as illustrated in Fig. 6B. Then, as illustrated in Fig. 6A, the rising metallic film 68 on the insulating portion 49 is horizontally cut with a dicer 69, or polished with a grinder to expose the upper surface of the insulating portion 49. At this point, as illustrated in Fig. 6C, the insulating portion 49 is not ground flat, but the insulating portion 49 is projected from the periphery, whereby a rising portion 68a of the metallic film 68 is formed in both side surfaces of the insulating portion 49.

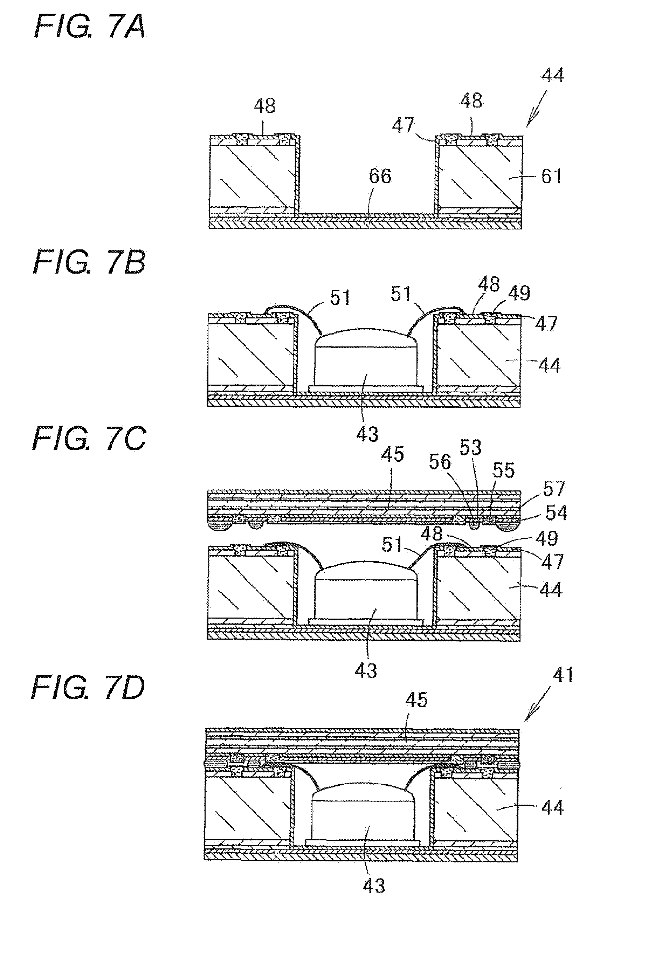

When the metallic film 68 with which the upper surface of the insulating portion 49 is coated is removed to expose the upper surface of the insulating portion 49, as illustrated in Fig. 7A, the metallic film 68 in the region surrounded by the insulating portion 49 constitutes the bonding pad 48 while other regions constitute the electromagnetically-shielding conductive layer 47. Additionally, the insulating portion 49 and the metallic films 68 in both the side surfaces of the insulating portion 49 are projected upward, so that the conductive member 56 that joins the bonding pad 48 and the connecting pad portion 53 or the conductive member 57 that joins the conductive layer 47 and the ground electrode layer 54 can be prevented from flowing out beyond the insulating portion 49 to generate a short circuit when the cover 44 and the substrate 45 are bonded by the conductive members 56 and 57.

When the cover 44 is finished, as illustrated in Fig. 7B, the sensor 42 and the circuit element 43 are accommodated in the recess 46, the bottom surface is rigidly bonded, the sensor 42 and the circuit element 43 are bonded by the bonding wire 50, and the circuit element 43 and the bonding pad 48 are connected by the bonding wire 51.

Then, the conductive member 56 is applied onto the connecting pad portion 53 while the conductive member 57 is applied onto the outer peripheral portion in the lower surface of the separately-prepared substrate 45 illustrated in Fig. 4B, the substrate 45 is overlapped on the cover 44 as illustrated in Fig. 7C, the bonding pad 48 and the connecting pad portion 53 are joined by the conductive member 56 as illustrated in Fig. 7D, and the conductive lawyer 47 and the ground electrode layer 54 are joined by the conductive member 57.

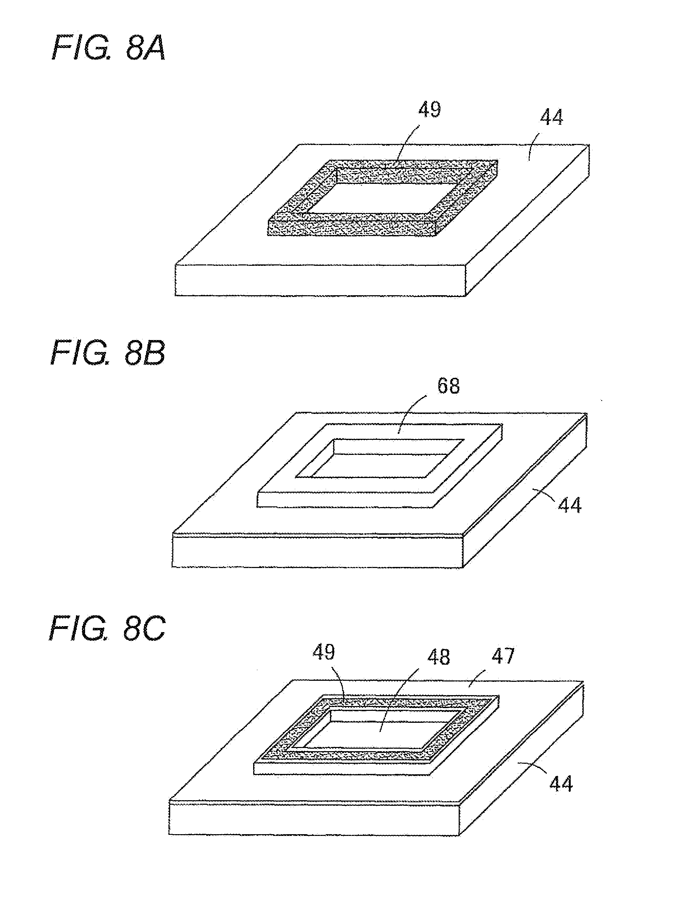

Figs. 8A to 8C are views schematically illustrating processes of preparing the bonding pad 48 and the conductive layer 47 in the method for producing the semiconductor device 41 (Figs. 5 to 7). Fig. 8A illustrates a state in which the insulating portion 49 is formed into the frame shape in the surface of the cover 44, and corresponds to Fig. 5C. Fig. 8B illustrates a state in which the insulating portion 49 is coated with the metallic film 68, and Fig. 8B corresponds to Fig. 5E. Fig. 8C illustrates a state in which the metallic film 68 with which the insulating portion 49 is coated is removed, and Fig. 8C corresponds to Fig. 7A. In the method of first embodiment, the insulating portion 49 that is previously provided into the frame shape is coated with the metallic film 68, and the portion (and the insulating portion 49) with which the upper surface of the insulating portion 49 is coated in the metallic film 68 is ground or polished with the dicer to expose the insulating portion 49. Therefore, in patterning the metallic film 68, it is not necessary to use the photolithographic technique unlike the conventional method. Because the insulating portion 49 is buried between the bonding pad 48 and the conductive layer 47 in the process of preparing the bonding pad 48, it is not necessary to bury the insulting material between the bonding pad 48 and the conductive layer 47 in the subsequent process. Therefore, the bonding pad 48 can inexpensively be prepared through the simple process.

In the first embodiment, when the insulating portion 49 is left while projected, the height of the edge of the bonding pad 48 is increased, the conductive member hardly flows out, and the short circuit caused by the conductive member can be prevented.

### (Second Embodiment)

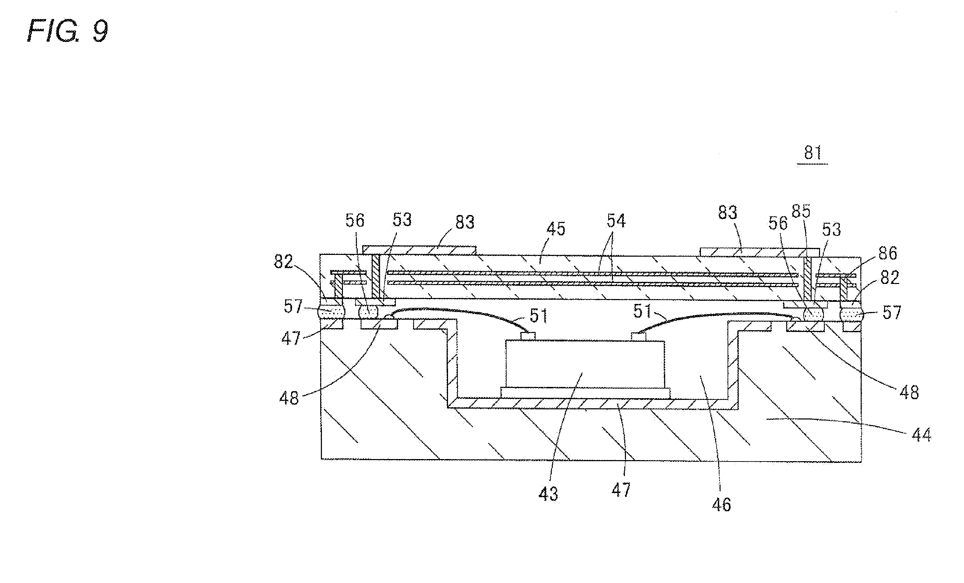

The cover 44 that is of a molding product is used in a semiconductor device 81 according to a second embodiment of the invention. Fig. 9 is a sectional view illustrating the semiconductor device 81. The cover 44 is a resin molding product made of a non-conductive resin, and the recess 46 is formed in the upper surface of the cover 44. The electromagnetically-shielding conductive layer 47 and the bonding pad 48 are formed in the inner surface of the recess 46 and the upper surface of the cover 44. The sensor 42 and the circuit element 43 are mounted on the bottom surface of the recess 46, and the circuit element 43 and the bonding pad 48 are connected by the bonding wire 51.

The substrate 45 for the package includes a multilayer wiring substrate, the electromagnetically-shielding ground electrode layer 54 is provided in the substrate 45, and an external connection terminal 83 that constitutes signal input/output means is provided in the upper surface of the substrate 45. In the lower surface of the substrate 45, the connecting pad portion 53 that is electrically connected to the external connection terminal 83 through a via hole 85 is provided opposite the bonding pad 48, and a ground electrode 82 that is electrically connected to the ground electrode layer 54 through a via hole 86 is provided in the outer peripheral portion.

The substrate 45 is overlapped on the upper surface of the cover 44, the bonding pad 48 to which the bonding wire 51 is connected is connected to the connecting pad portion 53 by the conductive member 56, and the conductive layer 47 is connected to the ground electrode 82 by the conductive member 57.

### (Producing Method)

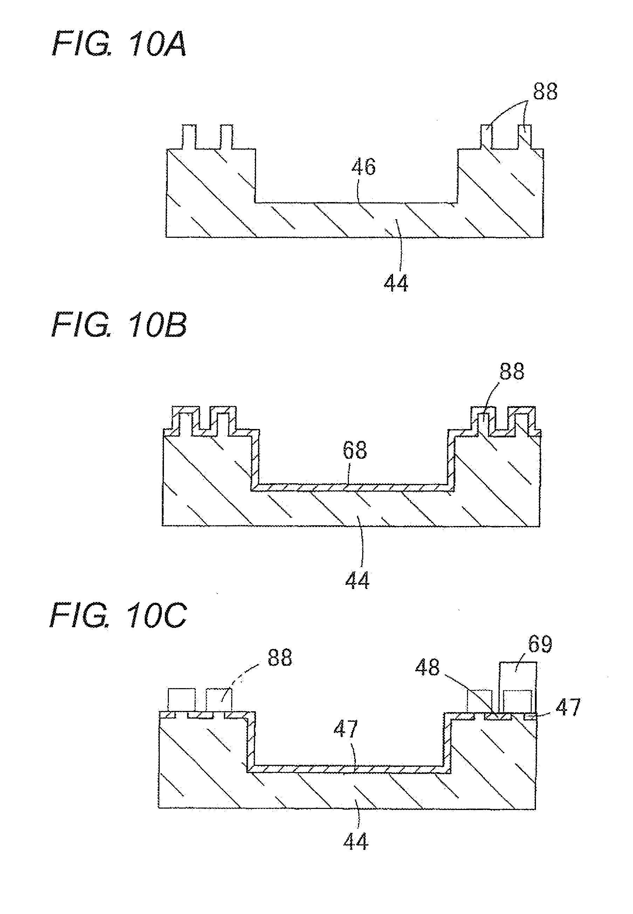

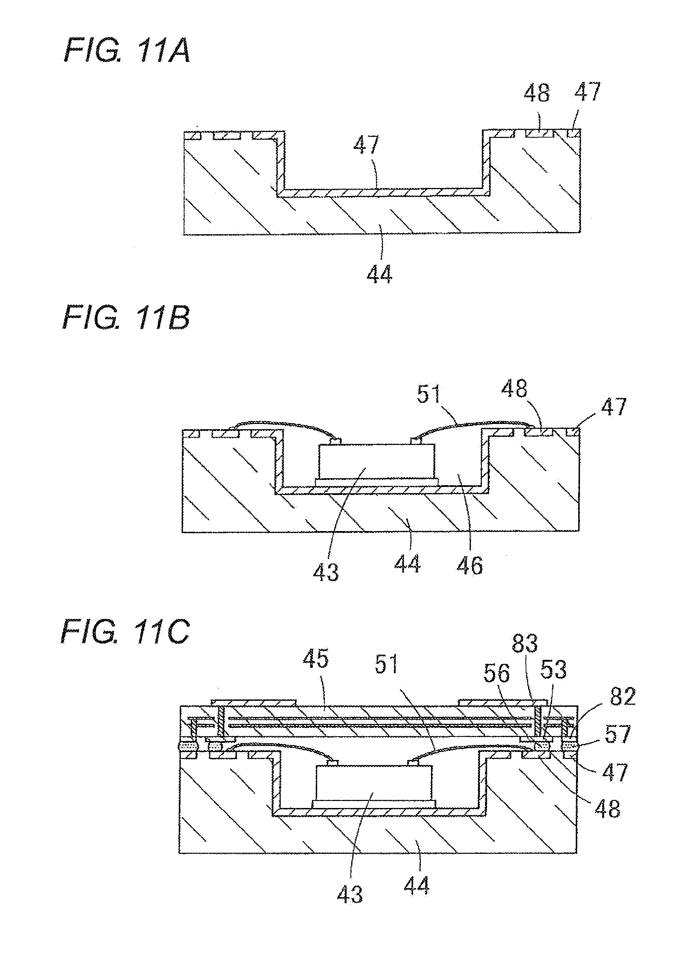

Figs. 10A to 10C and Figs. 11A to 11C are schematic sectional views illustrating a method for producing the semiconductor device 81 of the second embodiment. The method for producing the semiconductor device 81 will be described with reference to these drawings.

Fig. 10A illustrates the cover 44 that is molded using the non-conductive resin, the box-shaped recess 46 is provided in the upper surface, and a frame-shaped projection 88 is provided outside the recess 46 so as to surround the region where the bonding pad 48 is to be formed. As illustrated in Fig. 10B, the metallic film 68 is formed in the whole inner surface of the recess 46 of the cover 44 and the whole upper surface outside the recess 46 by metallic plating. Then, as illustrated in Fig. 10C, the frame-shaped projection 88 is ground with a dicer 69 or a grinder, and the metallic film 68 is partially removed in the region where the frame-shaped projection 88 is projected, thereby exposing the cover 44. As a result, as illustrated in Fig. 11A, the independent bonding pad 48 is formed in the region surrounded by the frame-shaped projection 88, and the conductive layer 47 is formed in other regions. The periphery of the bonding pad 48 is separated from the conductive layer 47, and the bonding pad 48 and the conductive layer 47 are insulated from each other by the cover 44 that is exposed to the point at which the frame-shaped projection 88 was provided.

Then, as illustrate in Fig. 11B, the sensor 42 and the circuit element 43 are accommodated in the recess 46 and fixed using a bonding agent, and the sensor 42 and the circuit element 43 are connected by the bonding wire 50. The circuit element 43 and the bonding pad 48 are connected by the bonding wire 51.

Then, the substrate 45 is overlapped on the cover 44, the bonding pad 48 and the connecting pad portion 53 are connected by the conductive member 56 such as the conductive bonding agent and the solder, and the outer peripheral portions of the conductive layer 47 and ground electrode 82 are connected by the conductive member 57 such as the conductive member and the solder.

In the second embodiment, the bonding pad 48 becomes flattened. Therefore, when the wire bonding is performed to the bonding pad 48, a jig hardly interferes with the bonding pad 48, which facilitates the wire bonding.

### (Third Embodiment)

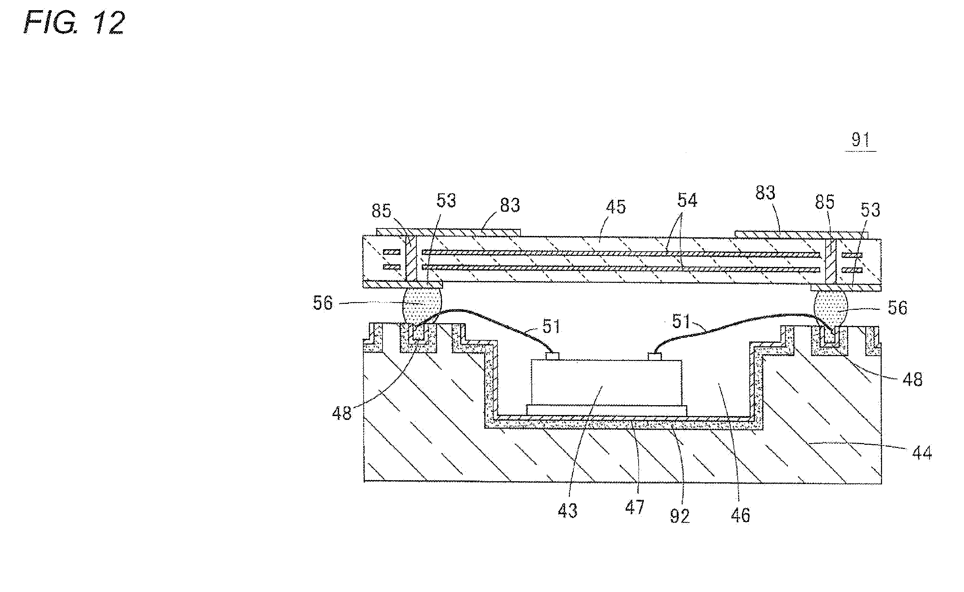

The cover 44 that is of a shaped product made of conductive resin or metal is used in a semiconductor device 91 according to a third embodiment of the invention. Fig. 12 is a sectional view illustrating the semiconductor device 91. The cover 44 is the shaped product made of the conductive resin or metal, and the recess 46 is formed in the upper surface of the cover 44. The inner surface of the recess 46 and the upper surface of the cover 44 are coated with an insulating film 92, and the electromagnetically-shielding conductive layer 47 and the bonding pad 48 are formed on the insulating film 92. In the bottom surface of the recess 46, the sensor 42 and the circuit element 43 are mounted on the conductive layer 47, and the circuit element 43 and the bonding pad 48 are connected by the bonding wire 51.

The substrate 45 for the package includes a multilayer wiring substrate, the electromagnetically-shielding ground electrode layer 54 is provided in the substrate 45, and the external connection terminal 83 that constitutes signal input/output means is provided in the upper surface of the substrate 45. In the lower surface of the substrate 45, the connecting pad portion 53 that is electrically connected to the external connection terminal 83 through the via hole 85 is provided opposite the bonding pad 48.

The substrate 45 is overlapped on the upper surface of the cover 44, the bonding pad 48 to which the bonding wire 51 is connected is connected to the connecting pad portion 53 by the conductive member 56.

### (Producing Method)

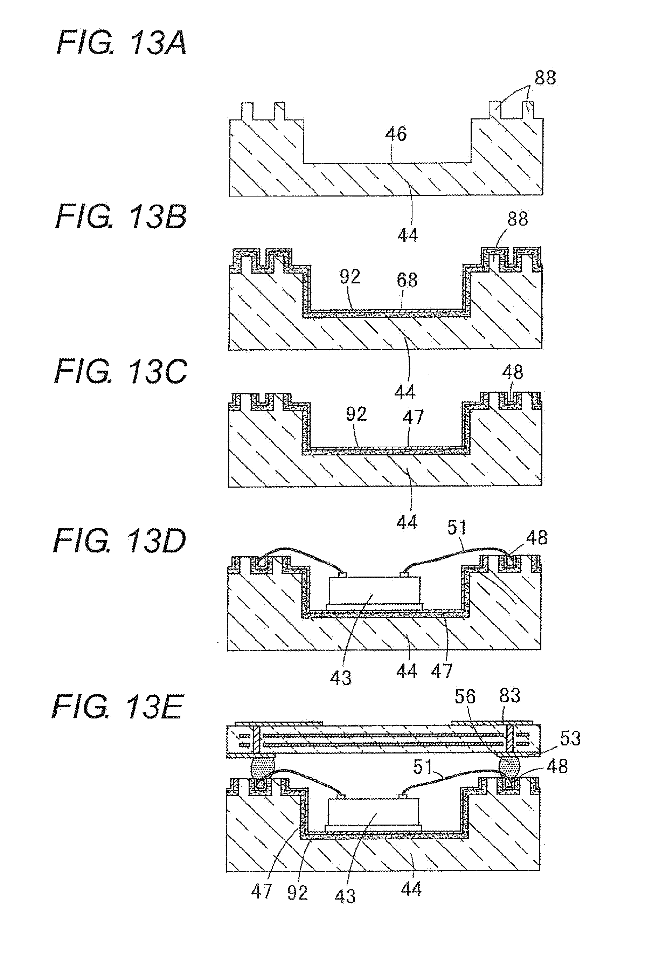

Figs. 13A to 13E are schematic sectional views illustrating a method for producing the semiconductor device 91 of the third embodiment. The method for producing the semiconductor device 91 will be described with reference to these drawings.

Fig. 13A illustrates the cover 44 that is shaped using the conductive resin or metallic material, the box-shaped recess 46 is provided in the upper surface, and the frame-shaped projection 88 is provided outside the recess 46 so as to surround the region where the bonding pad 48 should be formed. As illustrated in Fig. 13B, the whole inner surface of the recess 46 of the cover 44 and the whole upper surface outside the recess 46 are coated with the insulating film 92 to form the metallic film 68 on the insulating film 92. Then, as illustrated in Fig. 13C, the frame-shaped projection 88 is partially ground with a dicer or a grinder to expose the upper surface of the frame-shaped projection 88 from the metallic film 68. As a result, the independent bonding pad 48 is formed in the region surrounded by the frame-shaped projection 88, and the conductive layer 47 is formed in other regions. The bonding pad 48 is insulated from the conductive layer 47 and the cover 44 by the insulating film 92.

Then, as illustrated in Fig. 13D, the sensor 42 and the circuit element 43 are accommodated in the recess 46 and fixed using a bonding agent, and the sensor 42 and the circuit element 43 are connected by the bonding wire 50. The circuit element 43 and the bonding pad 48 are connected by the bonding wire 51.

Then, the substrate 45 is overlapped on the cover 44, and the bonding pad 48 and the connecting pad portion 53 are connected by the conductive member 56 such as the conductive bonding agent and the solder.

### (Fourth Embodiment)

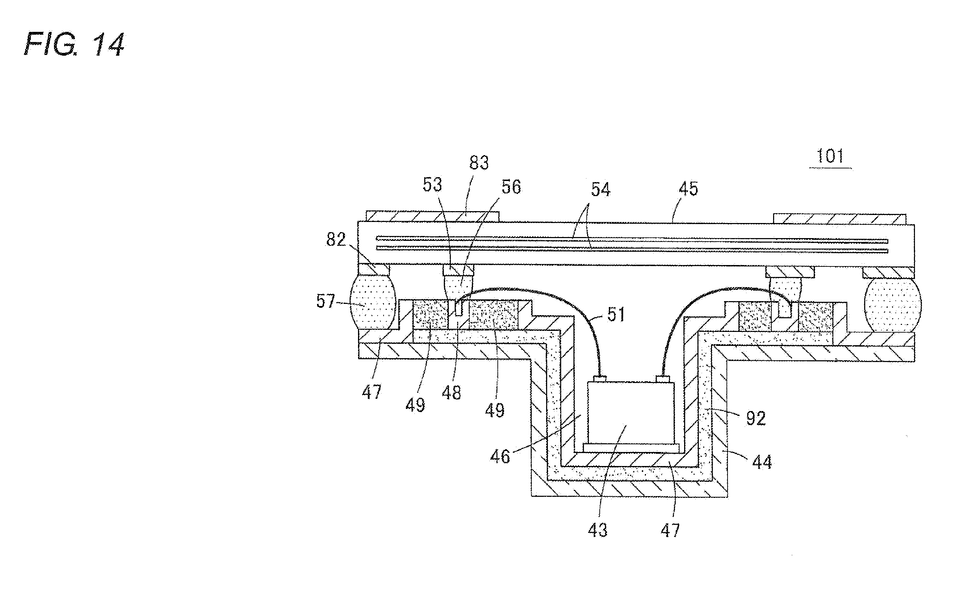

Fig. 14 is a sectional view illustrating a semiconductor device 101 according to a fourth embodiment of the invention. A metallic plate is used as the cover 44 in the semiconductor device 101 of the fourth embodiment.

In the cover 44 of the semiconductor device 101, the recess 46 is formed by bending work of the metallic plate such as a copper plate and an aluminum plate. The inner surface of the recess 46 and the upper surface of the cover 44 are coated with the insulating film 92, the electromagnetically-shielding conductive layer 47 and the bonding pad 48 are formed on the insulating film 92, and the bonding pad 48 and the conductive layer 47 are insulated from each other by the insulating portion 49. In the bottom surface of the recess 46, the sensor 42 and the circuit element 43 are mounted on the conductive layer 47, and the circuit element 43 and the bonding pad 48 are connected by the bonding wire 51.

The substrate 45 for the package includes a multilayer wiring substrate, the electromagnetically-shielding ground electrode layer 54 is provided in the substrate 45, and the external connection terminal 83 that constitutes signal input/output means is provided in the upper surface of the substrate 45. The connecting pad portion 53 that is electrically connected to the external connection terminal 83 and the ground electrode 82 that is electrically connected to the substrate 45 are provided in the lower surface of the substrate 45.

### (Producing Method)

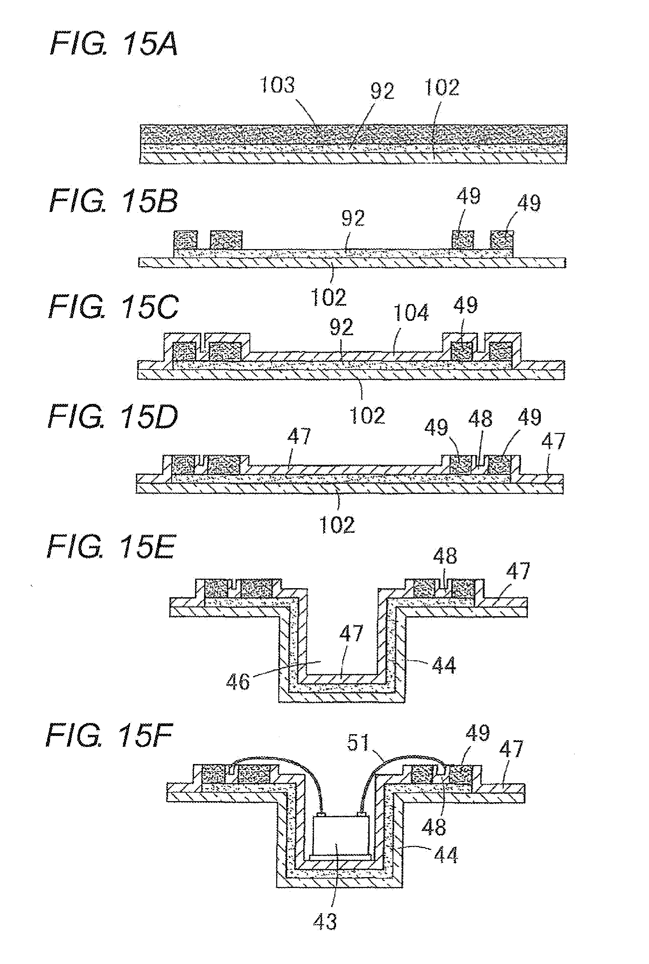

Figs. 15A to 15F are schematic sectional views illustrating a method for producing the semiconductor device 101 of the fourth embodiment. The method for producing the semiconductor device 101 will be described with reference to Figs. 15A to 15F.

Referring to Fig. 15A, the insulating film 92 is formed on a surface of a metallic plate 102 such as a copper plate and an aluminum plate, and an insulating layer 103 is formed on the metallic plate 102. Although the insulating film 92 and the insulating layer 103 may be made of the same kind of material, preferably they differ from each other in an etching property.

As illustrated in Fig. 15B, the insulating portion 49 is etched, and the insulating portion 49 is patterned into the frame shape so as to surround the region where the bonding pad 48 is provided. The outer peripheral portion of the insulating film 92 is removed to expose the outer peripheral portion of the metallic plate 102. Then, as illustrated in Fig. 15C, the whole of the metallic plate 102 is coated with the conductive material from above the insulating film 92 and the insulating portion 49, and a conductive film 104 is deposited. Further, as illustrated in Fig. 15D, the conductive film 104 with which the insulating portion 49 is coated is partially ground by a dicer or a grinder to expose the upper surface of the insulating portion 49 from the conductive film 104. As a result, the bonding pad 48 is formed in the region surrounded by the insulating portion 49 by the conductive film 104, and the conductive layer 47 is formed in other regions.

As illustrated in Fig. 15E, the metallic plate 102 is bent by the bending work to form the cover 44 including the recess 46. Then, as illustrated Fig. 15F, the sensor 42 and the circuit element 43 are accommodated in the recess 46 and fixed using a bonding agent, and the sensor 42 and the circuit element 43 are connected by the bonding wire 50. The circuit element 43 and the bonding pad 48 are connected by the bonding wire 51. Finally, the substrate 45 is overlapped on the cover 44, the bonding pad 48 and the connecting pad portion 53 are connected by the conductive member 56, and the conductive layer 47 and the ground electrode 82 are connected by the conductive member 57 to obtain the semiconductor device 101 illustrated in Fig. 14.

## Claims

1. A connecting pad producing method comprising:
a first process of projecting an insulating member (49) in a surface of a base material (61) such that a region where a connecting pad (53) is formed is surrounded;
a second process of forming a conductive layer (68) in the surface of the base material (61) such that the insulating member (49) is coated with the conductive layer (68); and
a third process of removing the conductive layer (68) with which the insulating member (49) is coated, exposing the insulating member (49) over a whole periphery from the conductive layer, and forming the connecting pad (53) including the conductive layer (68) in a region surrounded by the insulating member (49).

2. The connecting pad producing method according to claim 1, wherein the insulating member (49) is formed by adding an insulating material to the surface of the base material (61) in the first process.

3. The connecting pad producing method according to claim 1, wherein the insulating member (49) is formed integral with the base material (61) in the first process.

4. The connecting pad producing method according to claim 1, wherein the conductive layer (68) is provided in the surface of the base material (61) having conductivity through a coated film made of an insulating material in the second process,

5. The connecting pad producing method according to claim 1, wherein the conductive layer (68) with which the insulating member (49) is coated is removed so as not to reach a surface of the conductive layer (68) in a region adjacent to the insulating member (49) in the third process.

6. The connecting pad producing method according to claim 1, wherein the conductive layer (68) with which the insulating member (49) is coated and the insulating member (49) are removed to a surface of the conductive layer (68) in a region adjacent to the insulating member (49) in the third process.

7. The connecting pad producing method according to claim 1, wherein the conductive layer (68) is removed by machine work in the third process.

8. The connecting pad producing method according to claim 1, wherein the conductive layer (68) outside the region surrounded by the insulating member (49) is an electromagnetic shield.

9. The connecting pad producing method according to claim 1, wherein the base material (61) includes a recess (45),
the insulating member (49) is formed in the surface of the base material (61) in a region outside the recess (45) in the first process, and
the conductive layer (68) is formed in the whole surface of the base material (61) including an inner surface of the recess (45) in the second process.

10. The connecting pad producing method according to claim 1, wherein the base material (61) is a member that constitutes at least part of a package for accommodating a semiconductor element.
